# EUROPÄISCHE PATENTSCHRIFT

(11) **EP 0 781 186 B1**
(45) Veröffentlichungstag und Bekanntmachung des Hinweises auf die Patenterteilung: **24.03.1999**
(21) Anmeldenummer: 95929761.5
(22) Anmeldetag: 04.09.1995
(51) Int. Cl.: B23K 1/20, H05K 3/34

(54) **VERFAHREN ZUR BELOTUNG VON ANSCHLUSSFLÄCHEN, SOWIE VERFAHREN ZUR HERSTELLUNG EINER LOTLEGIERUNG**
METHOD OF APPLYING SOLDER TO CONNECTION SURFACES, AND METHOD OF PRODUCING A SOLDER ALLOY
PROCEDE D'APPLICATION DE BRASURE SUR DES SURFACES DE CONNEXION ET PROCEDE DE PRODUCTION D'UN ALLIAGE DE BRASAGE

(30) Priorität: 15.09.1994 DE 4432774
(43) Veröffentlichungstag der Anmeldung: 02.07.1997
(73) Patentinhaber: FRAUNHOFER-GESELLSCHAFT ZUR FÖRDERUNG DER ANGEWANDTEN FORSCHUNG E.V., 80636 München (DE)
(72) Erfinder: ZAKEL, Elke, D-12163 Berlin (DE)
(74) Vertreter: Böck, Bernhard, Dipl.-Ing.
(86) Internationale Anmeldenummer: DE9501209
(87) Internationale Veröffentlichungsnummer: WO9608337

(56) Entgegenhaltungen:
- EP-A- 0 463 297
- WO-A-86/04002
- DE-A- 3 433 844
- US-A- 5 125 560
- WELDING JOURNAL RESEARCH SUPPLEMENT, Bd. 53, Nr. 7, Juli 1974 MIAMI ( USA ), Seiten 498-s-509-s, D.SCHOENTHALER 'Solder fusing with heated liquids'
- PATENT ABSTRACTS OF JAPAN vol. 16 no. 389 (E-1250) ,19.August 1992 & JP,A,04 127436 (SHARP CORP.) 28.April 1992,

## Beschreibung

Die vorliegende Erfindung betrifft ein Verfahren zur Belotung von Anschlußflächen eines Substrats mit schmelzflüssigem Lot gemäß den Oberbegriffen der Ansprüche 1 und 6, sowie ein Verfahren zur Herstellung einer Lotlegierung aus mindestens zwei Lotkomponenten gemäß dem Anspruch 9.

An die Qualität und Zuverlässigkeit von Lotverbindungen werden nicht zuletzt wegen der zunehmenden Miniaturisierung von elektronischen Bauteilen und der immer höheren Integrationsdichten von ICs ständig steigende Anforderungen gestellt. Die Erfüllung dieser Anforderungen mit den bekannten, industriell anwendbaren Techniken setzt einen erheblichen Aufwand voraus, der sich in entsprechender Weise bei den Herstellungskosten bemerkbar macht. Eine weite Verbreitung hat mittlerweile die Lotpastentechnologie in Verbindung mit dem Reflow-Verfahren gefunden. Dabei wird in einem ersten Verfahren pastöses Lotmaterial auf die Anschlußflächen aufgebracht und in einem zweiten Verfahren die für die Lötreaktion erforderliche Wärme eingebracht. In der Praxis erweist es sich dabei häufig als ein großes Problem, die für das Reflow-Verfahren benötigte Wärmemenge so gezielt und dosiert einzubringen, daß einerseits ein Lötauftrag mit einem möglichst homogenen Gefüge ausgebildet wird, andererseits das Entstehen irreparabler Schäden innerhalb der elektronischen Bauteile durch Überhitzung vermieden wird.

Darüber hinaus ist es bei dem bekannten Reflow-Verfahren je nach Höhe der Qualitätsanforderungen, die an eine Lotverbindung gestellt werden, notwendig, das Verfahren in einer inerten Atmosphäre durchzuführen, was dazu führt, daß allein die Kosten, die mit der Bereitstellung entsprechender Betriebseinrichtungen verbunden sind, extrem hoch sind.

Aus dem mächstkommenden Stand der Technik gemäß DE-A1-3 433 844 ist ein Verfahren zur selektiven Belotung von Anschlußflächen eines Substrats bekannt, bei dem das Substrat in ein temperiertes, flüssiges, organisches Medium eingebracht wird und Lotmaterial innerhalb des Mediums auf das Substrat aufgebracht wird. Bei dem bekannten Verfahren wird das Lotmaterial im wesentlichen flächendeckend mittels einer über die gesamte Substratbreite reichenden Überlaufwanne auf die Substratoberfläche aufgetragen. Zur Ausbildung einer selektiven Belotung der Substratoberfläche mit Lotbumps, die hinsichtlich ihrer Verteilung auf der Substratoberfläche in ihrer Dicke definiert sind, wird bei dem bekannten Verfahren eine Egalisierungseinrichtung eingesetzt, die dazu dient, überschüssiges Lötmittel zu entfernen und die Stärke des Lötmittelniederschlags auf dem behandelten Werkstück zu steuern.

Aus WELDING JOURNAL RESEARCH SUPPLEMENT, Band 53, Nr. 7, Juli 1974, MIAMI (USA), Seiten 498-s - 509-s, D-SCHOENTHALLER, "Solder fusing with heated liquids" ist ein Verfahren bekannt, bei dem sogenannte "solder preforms" auf die Anschlußflächen aufgebracht werden, in die "solder preforms" dann die Anschlüsse von Bauelementen eingesetzt werden, um die "solder preforms" an Ort und Stelle zu halten. Anschließend erfolgt ein Umschmelzen der "solder preforms", wobei die Form und Anordnung der nach dem Umschmelzen entstehenden Lotbumps im wesentlichen durch die mechanische Vorfixierung über die Bauteilanschlüsse definiert wird.

Der vorliegenden Erfindung liegt die Aufgabe zugrunde, ein Verfahren bereitzustellen, das die Erzeugung hochwertiger und zuverlässiger Lötverbindungen auf möglichst einfache Art und Weise ermöglicht.

Diese Aufgabe wird durch ein Verfahren mit den Merkmalen des Anspruchs 1 gelöst.

Das erfindungsgemäße Verfahren ermöglicht die selektive Belotung von Anschlußflächen eines Substrats in einer durch ein flüssiges, organisches Medium gebildeten Umgebung. Das Substrat kann als beliebiges, mit einer oder mehreren Anschlußflächen versehenes Trägermaterial ausgebildet sein, wie zum Beispiel Wafer, Leiterplatten, Keramiksubstrate, u.s.w.. Sowohl der Lotauftrag als auch die Vergütung des Lotauftrags, die ansonsten mit dem bekannten Reflow-Verfahren in einem nachgeordneten Verfahren erreicht wird, erfolgt in einem einzigen Verfahren. Hierbei macht man sich zum einen die vorteilhaften Wirkungen des flüssigen, organischen Mediums zunutze, das, wie sich in Versuchen herausgestellt hat, sowohl reduzierend auf die zu benetzende Oberfläche wirkt, als auch die Benetzungsfähigkeit des Lotmaterials erhöht. Zum anderen ermöglicht die Temperierung des Lotmaterials über das flüssige, organische Medium einen gleichmäßigen, gut regelbaren Wärmeeintrag in das Lotmaterial. Das Ergebnis ist ein im wesentlichen homogener Gefügeaufbau im Lotauftrag und eine exakt einstellbare Diffusionstiefe zwischen dem Lotauftrag und der Anschlußfläche, um eine Lötverbindung mit den gewünschten Eigenschaften zu erreichen.

Im Vergleich zu den bekannten Verfahren, die neben der verfahrenstechnischen Aufteilung in ein Lötpastenauftrag und in ein anschließendes Reflow-Verfahren eine insbesondere in gerätetechnischer Hinsicht komplex aufgebaute Erwärmungseinrichtung zur Regelung der Temperatur während des Reflow-Verfahrens benötigen, kann der Wärmeeintrag beim erfindungsgemäßen Verfahren neben der Temperierung des Mediums auf einfache Art und Weise durch die Verweilzeit im Medium bestimmt werden. Dabei ist es auch möglich, Überhitzungseffekte dadurch zu vermeiden, daß die Verweildauer in mehrere Phasen aufgeteilt wird, zwischen denen eine Trennung des Mediuums von der mit dem Lotauftrag versehenen Anschlußfläche erfolgt. Hierdurch wird es auch möglich, unterschiedliche Materialien als Lotschichten aufeinander abzuscheiden und geschichtete Lotbumps aufzubauen. Neben der genau einstellbaren, und damit verbesserten Lötverbindungsqualität ermöglicht somit das erfindungsgemäße Verfahren die Durchführung von Belotungen mit einem wesentlich geringeren gerätetechnischen Aufwand.

Die selektive Belotung wird bei dem erfindungsgemäßen Verfahren dadurch ermöglicht, daß die Oberfläche des Substrats in benetzbare und nicht-benetzbare Teilflächen unterteilt ist, wodurch eine Haftung des Lotmaterials nur auf den benetzbaren Flächen erfolgt und ansonsten das Lotmaterial im Medium von den nicht-benetzbaren Teilflächen abperlt. Die jeweilige Benetzungsfähigkeit der Teilflächen läßt sich etwa durch eine entsprechende Oberflächengestaltung einstellen. Beispielsweise kann eine Differenzierung zwischen benetzbaren und nicht-benetzbaren Teilflächen durch einen Lötstoplackauftrag auf die Substratoberfläche unter Freilassung von benetzbaren, metallischen Teiloberflächen erreicht werden. Darüber hinaus stehen dem Fachmann zur Erreichung einer derartigen Differenzierung zwischen benetzbaren und nicht-benetzbaren Teilflächen eine Vielzahl von bekannten Möglichkeiten, wie beispielsweise auch der Maskenauftrag einer Passivierung, zur Verfügung. Hervorzuheben ist in jedem Fall, daß eine insgesamt maskenartige Gestaltung der Substratoberfläche mit sogenannter "Näpfchenbildung", bei der im Bereich der Anschlußflächen diskrete Vertiefungen zur Aufnahme des Lotmaterials geschaffen werden, zur Durchführung des erfindungsgemäßen Verfahrens nicht notwendig ist. Vielmehr macht man sich bei dem erfindungsgemäßen Verfahren zunutze, daß sich bei der Benetzung der benetzbaren Teilflächen mit Lotmaterial im Medium aufgrund der Oberflächenspannung des Lotmaterials meniskusartige Erhöhungen ausbilden, die eine Vertiefung in der Substratoberfläche überflüssig machen.

Bei einer möglichen Ausführungsform des erfindungsgemäßen Verfahrens wird zur Ausbildung des Lotbumps das Lot als Lotsumpf in einem aus dem Medium gebildeten Bad bereitgestellt. Das Aufbringen des Lots auf die Anschlußflächen erfolgt dabei durch ein zumindest teilweises Versenken des Substrats in den Lötsumpf und ein anschließendes Herausheben des Substrats aus dem Lötsumpf. Dabei erfolgt, wie vorstehend bereits erläutert, eine Benetzung der benetzbaren Anschlußflächen, wobei das Lotmaterial von den übrigen nicht-benetzbaren Flächenbereichen der Substratoberfläche beim Entfernen des Substrats aus dem Lotsumpf abperlt. Aufgrund der sich bei der Benetzung der benetzbaren Anschlußflächen ausbildenden Haftkräfte zwischen dem Lot und den Anschlußflächen kann diese Verfahrensvariante mit beliebig orientierten Anschlußflächen, beispielsweise nach oben oder nach unten gerichteten Anschlußflächen, durchgeführt werden. Diese Verfahrensvariante erfordert aufgrund der Kombination eines Mediumbades mit darin enthaltenem Lötsumpf nur einen minimalen Aufwand in gerätetechnischer Hinsicht.

Als vorteilhaft erweist sich auch eine Verfahrensvariante, bei der das Lot als Lotschicht auf einem Lotsieb innerhalb des Mediums und oberhalb des Substrats angeordnet ist. Bei dieser Anordnung erfolgt das Aufbringen des Lots auf die Anschlußflächen durch einen aus Lotpartikeln gebildeten Siebaustrag sedimentartig. Dabei ermöglicht die sedimentartige Abscheidung der Lotpartikel auf den Anschlußflächen auch eine Benetzung von unregelmäßigen, zerklüfteten Oberflächen insbesondere in Vertiefungen der Oberfläche.

Als besonders vorteilhaft bei der selektiven Belotung erweist es sich, wenn das Lot als Lotsäule in einer von einem Lotreservoir gespeisten Kapillare innerhalb des Mediums angeordnet ist, und das Aufbringen des Lots auf die Anschlußflächen durch einen am Kapillarenaustritt gebildeten Meniskus erfolgt. Bei dieser Art der Belotung der Anschlußflächen ist es möglich, durch Regelung des vom Lotreservoir auf die Lotsäule ausgeübten Drucks die Größe des Meniskus zu bestimmen und somit die Größe des Lotauftrags auf den Anschlußflächen. Bei einer gesteuerten Relativbewegung zwischen der Kapillare und der Substratoberfläche läßt sich die Kapillare als "Lotgriffel" verwenden, wodurch es möglich wird, Lotbumps an beliebigen, diskreten Stellen auf der Substratoberfläche auszubilden. Dieses "Lotgriffel"-Verfahren wird besonders einfach realisierbar, wenn das Substrat in einer Ebene quer zur Kapillarenachse bewegt wird.

Eine weitere erfindungsgemäße Lösung der genannten Aufgabenstellung weist die Merkmale des Anspruchs 6 auf. Hierdurch wird ein weiteres Verfahren möglich, das eine Alternative zu dem vorstehend erläuterten Verfahren ist. Wie das vorstehend beschriebene Verfahren, macht auch die im folgenden beschriebene Verfahrensalternative von den vorteilhaften Wirkungen Gebrauch, die sich bei Verwendung eines flüssigen, organischen Mediums als Belotungsumgebung ergeben.

Bei dem weiteren erfindungsgemäßen Verfahren erfolgt im Unterschied zu dem vorstehend beschriebenen Verfahren die Aufbringung eines die Substratfläche im wesentlichen abdeckenden Lötauftrags vor der Einbringung des Substrats in das flüssige organische Medium. Die Einbringung des Substrats erfolgt dann zusammen mit dem Lötauftrag in das Medium, dessen Siedetemperatur oberhalb der Schaelztemperatur des Lotauftrags liegt und das zumindest zeitweise auf eine Temperatur oberhalb der Schmelztemperatur des Lotauftrags aufgeheizt wird.

Die vorgenannte, erfindungsgemäße Verfahrensalternative bietet die Möglichkeit, als Lotauftrag standardmäßige Lotmaterialien, wie beispielsweise eine Lotpartikelschicht, die vor Einbringung des Substrats in das Medium im wesentlichen flächendeckend auf die Substratoberfläche aufgetragen wird oder eine Lotfolie zu verwenden.

Neben den vorgenannten, erfindungsgemäßen Verfahrensalternativen läßt sich das erfindungsgemäße Prinzip, bei der Verarbeitung von Lotmaterial ein flüssiges, organisches Medium, als Lotumgebung zu verwenden, auch bei dem erfindungsgemäßen Verfahren zum Erschmelzen von Lotlegierungen anwenden, das die Merkmale des Anspruchs 9 aufweist.

Unter Anwendung des erfindungsgemäßen Grundprinzips ist es möglich, eine Lotlegierung aus mindestens zwei Lotkomponenten herzustellen, die in ihrer Zusammensetzung genau einstellbar ist. Hierbei erfolgt die Temperierung eines Bades aus dem organischen Medium, dessen Siedetemperatur oberhalb der Schmelztemperatur der Lotkomponenten liegt, auf eine Temperatur, die gleich oder größer der Schmelztemperatur der höchstschmelzenden Lotkomponente ist. Die Einbringung der Lotkomponenten in das Medium kann in festem bis schmelzflüssigem Zustand erfolgen.

Wie bei den vorstehend erläuterten, erfindungsgemäßen Belotungsverfahren wird durch das Medium auf einfache Art und Weise eine inerte Umgebung geschaffen, die ein Umschmelzen der Lotkomponenten zu einer Legierung in einer reduzierenden Umgebung ermöglicht. Dabei erfolgt der zum Umschmelzen erforderliche Wärmeeintrag über das Medium. Die Zusammensetzung derartig erschmolzener Legierungen stimmt exakt mit der Zusammensetzung des in das Mediumbad eingegeben Lotmaterials überein.

Abweichend von den herkömmlichen Legierungsverfahren, wie den galvanischen Verfahren, dem Aufdampfen oder Sputtern ist die endgültige Zusammensetzung der Lötbumps nicht von sich ändernden Konvektionsverhältnissen oder unterschiedlichen lokalen Stromdichten abhängig.

Das erfindungsgemäße Umschmelzverfahren ermöglicht somit auf einfache Art und Weise die Ausbildung von binären, ternären oder komplexeren, insbesondere bleifreien Lotlegierungen, die in ihrer Zusammensetzung genau einstellbar sind. Insbesondere bei Temperierung des Mediums auf Siedetemperatur ist sichergestellt, daß im Bad eine homogene Temperaturverteilung herrscht, die zur Ausbildung eines entsprechend feinkörnigen, homogenen Gefüges des Lotlegierung führt. Dabei ist die Siedetemperatur des Bades sehr sicher dadurch einstellbar, daß dem Bad dauernd Energie zugeführt wird, so daß durch eine stationäre Verdampfung des Mediums ein selbstbegrenzendes System eingestellt wird.

Unabhängig davon, ob das das den Erfindungen zugrundeliegende, gemeinsame Lösungsprinzip, nämlich die Verwendung eines organischen, flüssigen Mediums als Lotumgebung bei der Lotverarbeitung, bei den Belotungsverfahren oder dem vorstehend genannten Umschmelzverfahren Anwendung findet, hat sich in Versuchen besonders die Verwendung von Glyzerin als Medium als vorteilhaft erwiesen. Bei weiteren Versuchen hat die Verarbeitung oder Erzeugung von Zinn-Blei-Lotlegierungen oder Gold-Zinn-Lotlegierungen in Glyzerin als Medium zu besonders guten Ergebnissen geführt. Dies betrifft sowohl eutektische als auch nah-eutektische Legierungen mit einer Schmelztemperatur zwischen 183° Celsius und 290° Celsius, wobei Glyzerin eine Siedetemperatur von ca. 290° Celsius aufweist. Als Medium sind auch andere, flüssige organische Substanzen, wie Mineralöl oder Paraffin einsetzbar. Entscheidend für die Verwendung einer bestimmten Substanz als Medium ist die Tatsache, daß die Löttemperatur des Mediums gleich oder oberhalb der Schmelztemperatur des höchstschmelzenden Lotbestandteils ist. Dementsprechend ist es besonders vorteilhaft, die Paarung von Lotbestandteilen und Medium entsprechend aufeinander abzustimmen.

Nachfolgend werden beispielhafte Ausführungsformen der erfindungsgemäßen Verfahren zur Belotung von Anschlußflächen anhand der Zeichnungen näher erläutert. Es zeigen:
Fig. 1a - 1c eine erste Verfahrensvariante zur Belotung von Substrat-Anschlußflächen;
Fig. 2a - 2c eine zweite Verfahrensvariante zur Belotung von Substrat-Anschlußflächen;
Fig. 3a - 3c eine dritte Verfahrensvariante zur Belotung von Substrat-Anschlußflächen;
Fig. 4a - 4b eine vierte Verfahrensvariante zur Belotung von Substrat-Anschlußflächen;
Fig. 5a - 5b eine fünfte Verfahrensvariante zur Belotung von Substrat-Anschlußflachen;
Fig. 6 eine mit der vierten Verfahrensvariante hergestellte Lotbump-Verteilung auf einer Substratoberfläche;
Fig. 7 eine Querschnittsdarstellung eines Lotbumps der in Fig. 6 dargestellten Lotbump-Verteilung.

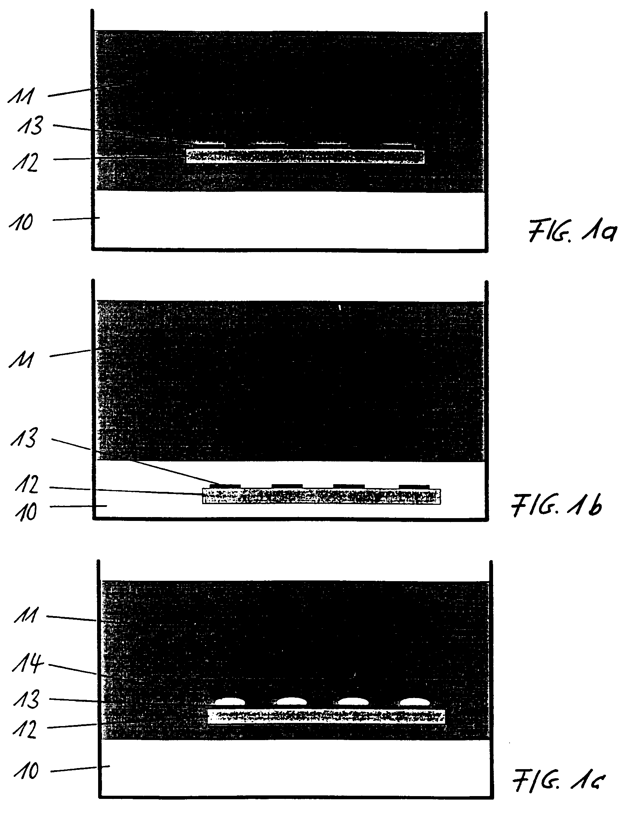

Fig. 1a - 1c zeigt in einer beispielhaften Darstellung eine erste Verfahrensvariante, bei der ein Lotsumpf in aus einer Zinn-Blei(SnPb)-Legierung in einem Bad 11 aus Glyzerin angeordnet ist. Oberhalb des Lotsumpfs befindet sich im Bad 11 ein Substrat 12, dessen Oberfläche mit einer Vielzahl von benetzbaren Flächen, die im folgenden als Pads 13 bezeichnet werden sollen, versehen ist (Fig. 1a). Das Bad 11 ist auf eine Temperatur oberhalb der Schmelztemperatur des Lotes, die im vorliegenden Fall etwa 183° Celsius beträgt, aufgeheizt.

Zur Benetzung der Pads 13 wird das Substrat 12 im Lotsumpf 10 versenkt (Fig. 1b) und anschließend wieder aus dem Lotsumpf 10 herausgehoben (Fig. 1c).

Die Darstellung gemäß Fig. 1c zeigt deutlich, daß nach dem Herausheben des Substrats 12 aus dem Lotsumpf 10 nur auf den Pads 13 ein Lotauftrag zur Ausbildung von Lotbumps 14 verbleibt und von den übrigen Oberflächenbereichen des Substrats 12 das Lot abgeperlt und in den Lotsumpf 10 zurückgelangt ist.

Die Lotbumps 14 weisen eine gleichmäßige Größe und Form auf, die nach Art eines Flüssigkeits-Meniskus ausgebildet ist und im wesentlichen durch die Viskosität des schmelzflüssigen Lotmaterials und dessen Haftung auf den Pads 13 bestimmt ist.

Neben der genannten Zinn-Blei-Legierung sind als weitere Beispiele für mögliche Lotlegierungen Gold-Zinn-, Indium-Zinn-, Indium-Blei-, Zinn-Silber-Legierungen oder chemisch reine Lote, wie Zinn oder Indium, bei dieser sowie den nachfolgend beschriebenen Verfahrensvarianten verwendbar.

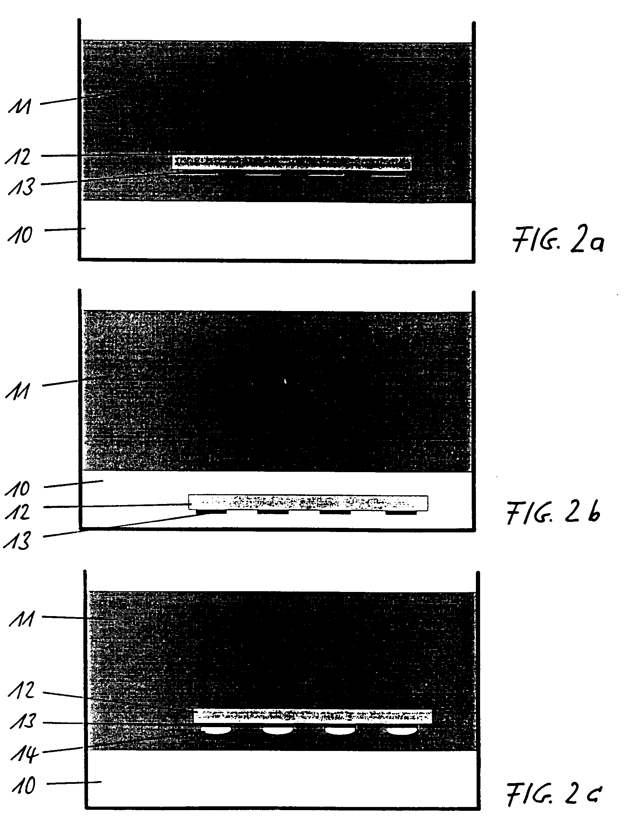

Die zweite, in den Fig. 2a bis 2c dargestellte Verfahrensvariante weist gegenüber der ersten, in den Fig. 1a bis 1c dargestellten Verfahrensvariante lediglich den Unterschied auf, daß das Substrat 12 mit nach unten gerichteten Pads 13 in den Lotsumpf 10 versenkt wird. Die hinsichtlich der Ausbildung der entstehenden Lotbumps 14 erzielten Resultate stimmen im wesentlichen mit den bei Anwendung der ersten Verfahrensvariante erzielten Resultate überein.

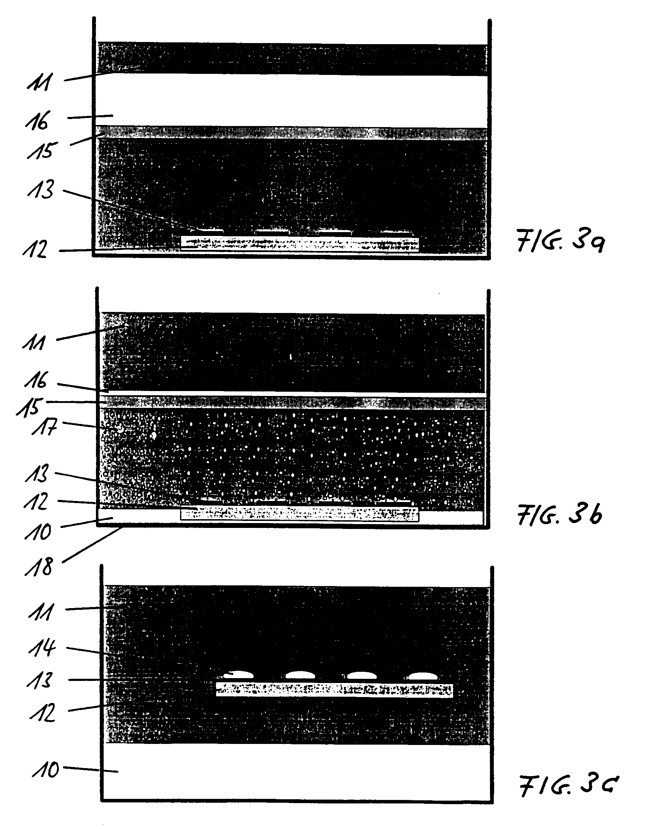

Die Fig. 3a bis 3c zeigen eine weitere mögliche, dritte Verfahrensvariante, bei der in dem auf eine Temperatur oberhalb der Schmelztemperatur des höchstschmelzenden Lotbestandteils temperierten Bad 11 auf einem Lotsieb 15 eine Lotschicht 16 angeordnet ist. Durch einen hier nicht näher dargestellten Druckstempel oder einfach durch Schwerkrafteinfluß gelangt ein aus Lotpartikeln 17 gebildeter Siebaustrag durch das Bad 11 auf die Oberfläche eines unterhalb des Lotsiebs 15 im Bad 11 angeordneten Substrats 12 (Fig.3b). Während der aus den Lotpartikeln 17 gebildete Siebaustrag sich durch das Medium auf das Substrat 12 zubewegt, kann dieses in Gegenrichtung bewegt werden oder an Ort und Stelle im Bad 11 verbleiben. In jedem Fall bildet sich durch sedimentartige Ablagerungen der Lotpartikel 17 auf den Pads 13 ein die Lotbumps 14 bildender Lotauftrag aus.

Wenn das Substrat 12 während der Abwärtsbewegung des Siebaustrags nach oben bewegt wird, erfolgt von vornherein eine Abscheidung der Lotpartikel 17 nur im Bereich der Pads 13, wohingegen in den übrigen Bereichen die Lotpartikel 17 quasi von der Oberfläche des Substrats 12 heruntergespült werden. Wenn das Substrat 12 während der Abwärtsbewegung der Lotpartikel 17 am Boden 18 des Bades 11 verbleibt, bildet sich eine nicht näher dargestellte Schicht aus Lotpartikeln 17 über die gesamte Oberfläche des Substrats 12 aus, wobei eine Ausbildung der Lotbumps 14 nur auf den Pads 13 erfolgt und in den übrigen Oberflächenbereichen die Lotpartikelschicht bei einer Aufwärtsbewegung des Substrats 12 im Bad 11 abgespült werden. In jedem Fall ist das Ergebnis wieder die Ausbildung von meniskusförmigen Lotbumps 14.

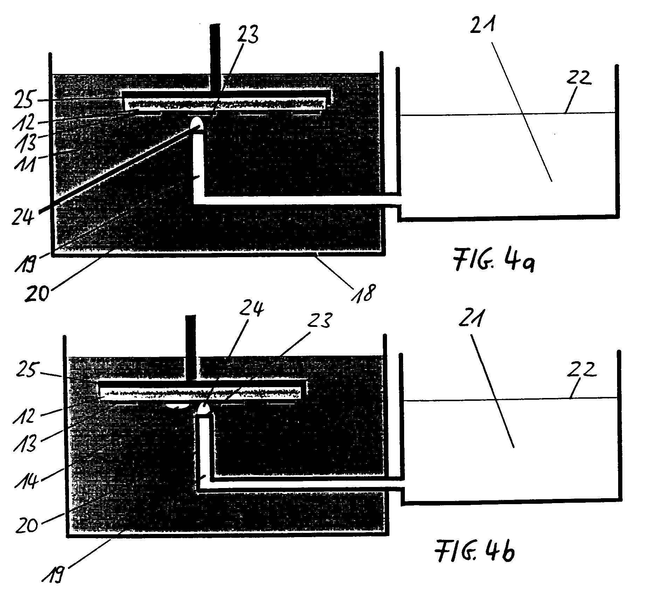

Die Fig. 4a und 4b zeigen schließlich eine vierte Variante zur Belotung von Substrat-Anschlußflächen, bei der das Lotmaterial als Lotsäule 19 in einer Kapillare 20 im Bad 11 angeordnet ist. Die Kapillare 20 befindet sich in Fluidverbindung mit einem Lotreservoir 21, dessen Pegel 22 zur Einstellung des Kapillarendrucks veränderbar ist. Je nach Höhe des Kapillarendrucks und der Größe des Kapillarenquerschnitts am Kapillarenaustritt 23 bildet sich dort ein Flüssigkeits-Meniskus 24 aus.

Oberhalb des Kapillarenaustritts 23 befindet sich im temperierten Bad 11 das Substrat 12 mit dem Kapillarenaustritt 23 zugewandten Pads 13. Das Substrat 12 wird von einer in einer Ebene quer zur Längserstreckung der Kapillare 20 und in Längserstreckung der Kapilare 20 bewegbaren Substrathalterung 25 im Bad 11 positioniert. Zur Ausbildung von Lotbumps 14 wird das Substrat 12 mit den Pads 13 mittels der Substrathalterung 25 so an dem am Kapillarenaustritt 23 ausgebildeten Flüssigkeitsmeniskus 24 vorbeibewegt, daß sich eine Benetzung der Pads 13 ergibt.

Wenn die Oberfläche des Substrats 12 ausschließlich der Pads 13 mit einer nicht-benetzbaren Beschichtung oder dergleichen versehen ist, kann das Substrat 12 zur Ausbildung der Lotbumps 14 einfach linear am Flüssigkeitsmeniskus 24 vorbeibewegt werden, wobei eine Benetzung nur auf den benetzbaren Pads 13 erfolgt. Dabei wird der Pegel 22 des Lotreservoirs 21 so nachgeregelt, daß am Kapillarenaustritt 23 für jedes Pad 13 der gewünschte Flüssigkeitsmeniskus 24 zur Verfügung steht.

Das in den Fig. 4a und 4b dargestellte Verfahren bietet darüber hinaus den Vorteil, daß eine selektive Belotung bestimmter Pads 13 erfolgen kann, indem der linearen, quer zur Längserstreckung der Kapillare 20 gerichteten Bewegung der Substrathalterung 25 eine Hubbewegung überlagert wird, derart, daß nur eine Benetzung ausgewählter Pads 13 durch den Flächenmeniskus 24 erfolgt. Die in den Fig. 4a bis 4b dargestellte Kapillare 20 ermöglicht somit eine Art "Lotgriffelfunktion".

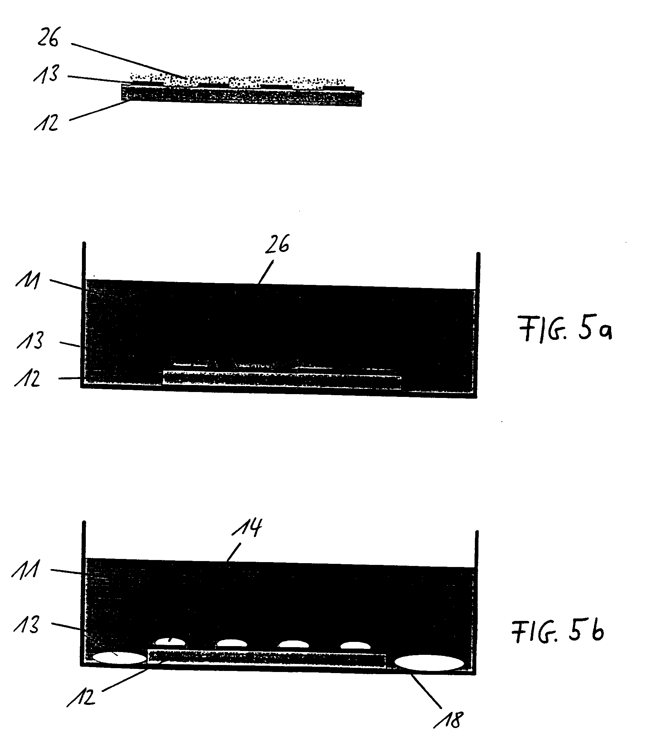

Die Fig. 5a und 5b zeigen schließlich eine Verfahrensvariante zur Belotung von Substrat-Anschlußflächen, bei der bereits vor Einbringung des Substrats 12 in das Bad 11 eine im wesentlichen die gesamte Substratoberfläche abdeckende Belegung mit festen Lotpartikeln 26 erfolgt.

Nach Belegung der Oberfläche des Substrats 12 wird dieses zusammen mit den darauf angeordneten Lotpartikeln 26 in das temperierte Bad 11 eingetaucht und verweilt dort, bis sich durch einen sogenannten "Lot-Reflow" im Bereich der Pads 13 Lotbumps 14 ausbilden, während gleichzeitig in den übrigen Oberflächenbereichen des Substrats 12 ein Abperlen der geschmolzenen Lotpartikel erfolgt, die sich am Boden 18 des Bads 11 sammeln.

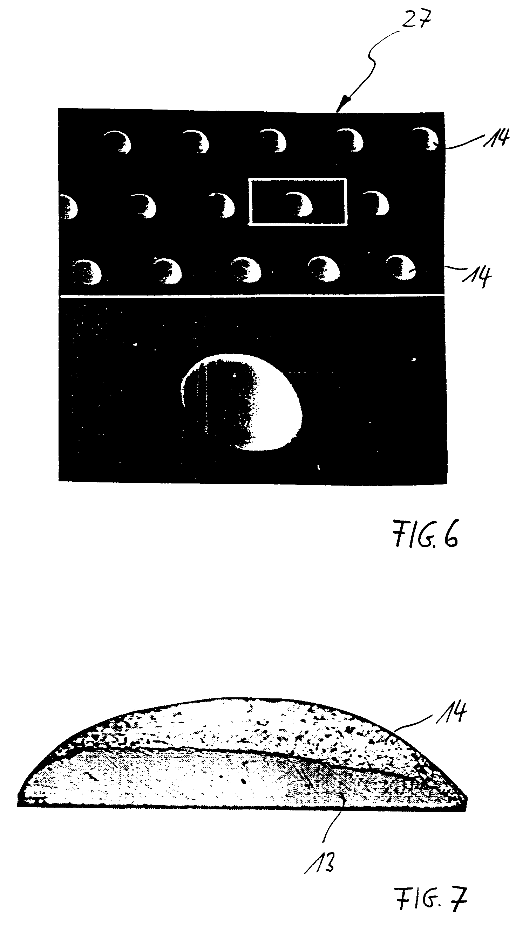

Fig. 6 zeigt in einer Draufsicht die Oberfläche eines Substrats 12 mit einer Lotbump Verteilung 27 aus einzelnen, meniskusartigen Lotbumps 14, die durch Benetzung auf den hier nicht näher dargestellten, bei diesem Beispiel kreisrund gestalteten Pads ausgebildet sind.

Wie die Querschnittdarstellung von Fig. 7 deutlich macht, sind die Lotbumps 14 kappenartig auf den Pads 13 ausgebildet. Die hier dargestellte Schnittdarstellung zeigt beispielhaft einen Lotbump 14 aus einer Zinn-Blei-Legierung (SnPb 63/37) auf einem Pad 13 aus Nickel. Bei diesem Beispiel besteht das Substrat aus einem Halbleiter und die Pads aus autokatalytisch abgeschiedenem Nickel.

An der Darstellung gemäß Fig. 6, die wie Fig. 7 eine Elektronenmikroskopaufnahme wiedergibt, fällt besonders auf, daß die im Benetzungsverfahren in einer Umgebung aus einem organischen, flüssigen Medium, in diesem Fall Glyzerin, auf die Pads 13 aufgebrachten Lotbumps 14 besonders gleichmäßig ausgebildet sind.

## Patentansprüche

1. Verfahren zur selektiven Belotung von Anschlußflächen (13) eines Substrats (12) mit mindestens einer mit Lot benetzbaren Anschlußfläche auf einer ansonsten nicht-benetzbaren Substratoberfläche,
wobei das Substrat in ein temperiertes, flüssiges, organisches Medium (11) eingebracht und Lotmaterial (10) innerhalb des Mediums auf das Substrat aufgebracht wird
dadurch **gekennzeichnet**,
daß als Medium (11) Glycerin oder ein hinsichtlich seines Grenzflächenverhaltens mit dem Glycerin gleichwirkendes Medium verwendet wird, dessen Siedetemperatur gleich oder oberhalb der Schmelztemperatur des Lotmaterials ist, und daß die Form und die Anordnung der Lotbumps (14) durch die Benetzungsfähigkeit der Substratoberfläche und das Grenzflächenverhalten des Glycerins bzw. des Mediums bestimmt werden.

2. Verfahren nach Anspruch 1,
dadurch **gekennzeichnet**,
daß das Lot als Lotsumpf (10) in einem aus dem Medium gebildeten Bad (11) enthalten ist, und das Aufbringen des Lots auf die Anschlußfläche(n) durch ein zumindest teilweises Versenken des Substrats (12) in den Lotsumpf (10) und ein anschließendes Entfernen des Substrats (12) aus dem Lotsumpf (10) erfolgt.

3. Verfahren nach Anspruch 1,
dadurch **gekennzeichnet**,
daß das Lot als Lotschicht (16) auf einem Lotsieb (15) innerhalb des Mediums und oberhalb des Substrats (12) angeordnet ist, und das Aufbringen des Lots auf die Anschlußfläche(n) durch ein aus Lotpartikeln (17) gebildeten Siebaustrag sedimentartig erfolgt.

4. Verfahren nach Anspruch 1,
dadurch **gekennzeichnet**,
daß das Lot als Lotsäule (19) in einer von einem Lotreservoir (21) gespeisten Kapillare (20) innerhalb des Mediums angeordnet ist, und das Aufbringen des Lots auf die Anschlußfläche(n) durch einen am Kapillarenaustritt (23) gebildeten Flüssigkeitsmeniskus (24) erfolgt.

5. Verfahren nach Anspruch 4,
dadurch **gekennzeichnet**,
daß zur Belotung mehrerer Anschlußflächen (13) eines Substrats (12) mit einer Kapillare (20) das Substrat (12) in einer Ebene quer zur Längserstreckung der Kapillare (20) bewegt wird.

6. Verfahren zur selektiven Belotung von Anschlußflächen (13) eines Substrats (12) mit mindestens einer mit Lot benetzbaren Anschlußfläche auf einer ansonsten nicht-benetzbaren Substratoberfläche, wobei das Substrat in ein temperiertes, flüssiges, organisches Medium (11) eingebracht wird,
dadurch **gekennzeichnet**,
daß das Substrat (12) zusammen mit einem die Substratoberfläche im wesentlichen abdeckenden Lotauftrag (26) in das Medium (11) eingebracht wird und als Medium Glycerin oder ein hinsichtlich seines Grenzflächenverhaltens mit dem Glycerin gleichwirkendes Medium verwendet wird, dessen Siedetemperatur gleich oder oberhalb der Schmelztemperatur des Lotauftrags ist, und daß die Form und die Anordnung der Lotbumps (14) durch die Benetzungsfähigkeit der Substratoberfläche und das Grenzflächenverhalten des Glycerins bzw. des Mediums bestimmt werden.

7. Verfahren nach Anspruch 6,
dadurch **gekennzeichnet**,
daß der Lotauftrag als Schicht aus festen Lotpartikeln (26) ausgebildet ist.

8. Verfahren nach Anspruch 6,
dadurch **gekennzeichnet**,
daß der Lotauftrag als Lotfolie ausgebildet ist.

9. Verfahren zur Herstellung einer Lotlegierung aus mindestens zwei Lotkomponenten mit den Verfahrensschritten:
- Temperierung eines Bades aus einem organischen Medium, dessen Siedetemperatur gleich oder oberhalb der Schmelztemperatur der höchstschmelzenden Lotkomponente liegt, auf eine Temperatur gleich oder oberhalb dieser Lotschmelztemperatur;
- Einbringung der Lotkomponenten in festem bis schmelzflüssigem Zustand in das Medium zur Ausbildung der Legierung.

10. Verfahren nach Anspruch 9,
dadurch **gekennzeichnet**,
daß das Medium zumindest während der Legierungsbildung auf Siedetemperatur gehalten wird.

11. Verfahren nach einem oder mehreren der vorangehenden Ansprüche,
dadurch **gekennzeichnet**,
daß als Medium Glyzerin verwendet wird.

## Claims

1. Method of selectively soldering terminal faces (13) of a substrate (12) having at least one solder-wettable terminal face on an otherwise non-wettable substrate surface, wherein the substrate is introduced into a tempered, liquid, organic medium (11) and solder material (10) is applied inside the medium onto the substrate,
characterized in
that, as a medium (11), glycerol or a medium which, in terms of its interfacial properties, has an identical effect to glycerol is used, said medium having a boiling temperature equal to or above the melting temperature of the solder material, and the shape and the arrangement of the solder bumps (14) are determined by the wettability of the substrate surface and the interfacial properties of the glycerol or the medium.

2. Method according to claim 1,
characterized in
that the solder is contained as a solder pool (10) in a bath (11) formed by the medium, and the application of the solder onto the terminal face(s) is effected by an at least partial lowering of the substrate (12) into the solder pool (10) and a subsequent removal of the substrate (12) from the solder pool (10).

3. Method according to claim 1,
characterized in
that the solder is disposed as a solder layer (16) on a solder screen (15) inside the medium and above the substrate (12), and the application of the solder onto the terminal face(s) is effected in the manner of a sediment by a screen discharge consisting of solder particles (17).

4. Method according to claim 1,
characterized in
that the solder is disposed inside the medium as a solder column (19) in a capillary (20) fed from a solder reservoir (21), and the application of the solder onto the terminal face(s) is effected by means of a liquid meniscus (24) formed at the capillary outlet (23).

5. Method according to claim 4,
characterized in
that, for soldering a plurality of terminal faces (13) of a substrate (12) using a capillary (20), the substrate (12) is moved in a plane perpendicular to the longitudinal extension of the capillary (20).

6. Method of selectively soldering terminal faces (13) of a substrate (12) having at least one solder-wettable terminal face on an otherwise non-wettable substrate surface, the substrate being introduced into a tempered, liquid, organic medium (11),
characterized in
that the substrate (12) together with a solder application (26) which substantially covers the substrate surface is introduced into the medium (11) and, as a medium, glycerol or a medium which, in terms of its interfacial properties, has an identical effect to glycerol is used, said medium having a boiling temperature equal to or above the melting temperature of the solder application, and the shape and the arrangement of the solder bumps (14) are determined by the wettability of the substrate surface and the interfacial properties of the glycerol or the medium.

7. Method according to claim 6,
characterized in
that the solder application takes the form of a layer of solid solder particles (26).

8. Method according to claim 6,
characterized in
that the solder application takes the form of a solder film.

9. Method of manufacturing a solder alloy of at least two solder components having the process steps:
- tempering of a bath of an organic medium, which has a boiling temperature equal to or above the melting temperature of the highest-melting solder component, up to a temperature equal to or above said solder melting temperature;
- introduction of the solder components in solid to molten state into the medium so as to form the alloy.

10. Method according to claim 9,
characterized in
that the medium at least during formation of the alloy is maintained at boiling temperature.

11. Method according to one or more of the preceding claims,
characterized in
that glycerol is used as a medium.

## Revendications

1. Procédé de brasage sélectif de surfaces de raccordement (13) d'un substrat (12) comportant au moins une surface de raccordement, pouvant être mouillée par la brasure, sur une surface du substrat qui par ailleurs n'est pas mouillable,
selon lequel on introduit le substrat dans un milieu liquide organique tempéré (11) et on dépose la brasure (10) à l'intérieur du milieu sur le substrat,
caractérisé en ce
qu'on utilise comme milieu (11) de la glycérine ou un milieu équivalent à la glycérine du point de vue de son comportement d'interface et dont la température d'ébullition est égale ou supérieure à la température de fusion de la brasure, et en ce que la forme et la disposition des plots de brasure (14) sont déterminées par la mouillabilité de la surface du substrat et le comportement d'interface de la glycérine ou du milieu.

2. Procédé selon la revendication 1, caractérisé en ce
que la brasure est contenue, en tant que réserve de brasure (10), dans un bain (11) formé par le milieu, et le dépôt de la brasure sur la ou les surfaces de raccordement est réalisé à l'aide d'un abaissement au moins partiel du substrat (12) dans la réserve de brasure (10), et on retire ensuite le substrat (12) de la réserve de brasure (10).

3. Procédé selon la revendication 1, caractérisé en ce
que la brasure est disposée sous la forme d'une couche de brasure (16) sur un tamis à brasure (15) à l'intérieur du milieu et au-dessus du substrat (12), et que le dépôt de la brasure sur la ou les surfaces de raccordement s'effectue sous la forme d'un sédiment avec un résidu extrait de tamisage formé de particules de brasure (17).

4. Procédé selon la revendication 1, caractérisé en ce
que la brasure est disposée sous la forme d'une colonne de brasure (19) dans un capillaire (20) alimenté par un réservoir à brasure (21), à l'intérieur du milieu, et en ce que le dépôt de la brasure sur la ou les surfaces de raccordement s'effectue à l'aide d'un ménisque de liquide (24) formé à la sortie (23) du capillaire.

5. Procédé selon la revendication 4, caractérisé en ce
que pour le brasage de plusieurs surfaces de raccordement (13) d'un substrat (12) à l'aide d'un capillaire (20), on déplace le substrat (12) dans un plan transversal par rapport à l'étendue longitudinale du capillaire (20).

6. Procédé de brasage sélectif de surfaces de raccordement (13) d'un substrat (12) comportant au moins une surface de raccordement, pouvant être mouillée par la brasure, sur une surface du substrat par ailleurs non mouillable, le substrat étant introduit dans un milieu liquide organique tempéré (11),
caractérisé en ce
que le substrat (12) est introduit, conjointement avec un revêtement de brasure (26) qui recouvre pour l'essentiel la surface du substrat, dans le milieu (11), en ce qu'on utilise comme milieu de la glycérine ou un milieu ayant un effet équivalent à celui de la glycérine en ce qui concerne son comportement d'interface et dont la température d'ébullition est égale ou supérieure à la température de fusion du revêtement de brasure, et en ce que la forme et la disposition des plots de brasure (14) sont déterminées par la mouillabilité de la surface du substrat et par le comportement d'interface de la glycérine ou du milieu.

7. Procédé selon la revendication 6, caractérisé en ce
que le dépôt de brasure est agencé sous la forme d'une couche formée de particules solides de brasure (26).

8. Procédé selon la revendication 6, caractérisé en ce
que le revêtement de brasure est agence sous la forme d'une feuille de brasure.

9. Procédé pour fabriquer un alliage de brasure à partir d'au moins deux constituants de brasure, présentant les étapes opératoires suivantes :
- mise en température d'un bain formé d'un milieu organique dont la température d'ébullition est égale ou supérieure à la température de fusion du constituant de la brasure qui a le point de fusion le plus élevé, à une température égale ou supérieure à cette température de fusion de la brasure ;
- introduction des constituants de la brasure d'un état solide jusqu'à un état fondu liquide, dans le milieu pour former l'alliage.

10. Procédé selon la revendication 9, caractérisé en ce
que le milieu est maintenu à la température d'ébullition au moins pendant la formation de l'alliage.

11. Procédé selon l'une ou plusieurs des revendications précédentes, caractérisé en ce qu'on utilise comme milieu, de la glycérine.
